# EUROPEAN PATENT APPLICATION

(11) **EP 4 776 070 A1**
(43) Date of publication of application: **15.07.2026**
(21) Application number: 25150630.9
(22) Date of filing: 08.01.2025
(51) Int. Cl.: G03F 7/20, G03F 1/76

(54) **METHOD FOR DETERMINING DOSAGE OF LASER SWEEPS FOR PRINTING A LINE IN A PATTERN AND CORRESPONDING SYSTEM FOR PRINTING A PATTERN**

(71) Applicant: MYCRONIC AB, 183 03 Täby (SE)
(72) Inventor: Ihrén, Fredric, 187 45 Täby (SE); Lobov, Gleb, 175 69 Järfälla (SE)
(74) Representative: AWA Sweden AB

(57) **Abstract**

A method for determining dosage of laser sweeps in a Y direction for printing a line in the Y direction of a pattern. The method comprises, receiving a target width in an X direction and a target position in the X direction of a line to be printed. The target width is equal to or larger than two pixels and less than or equal to three pixels. The X direction and the Y direction are perpendicular to each other. The method further comprises, determining, from empirical data, a respective dosage for each of a set of parallel laser sweeps to achieve the target width in the X direction and the target position in the X direction. The empirical data maps the target width in the X direction and the target position in the X direction to a required dosage for each laser sweep of the set of parallel laser sweeps for achieving the target width in the X direction and the target position in the X direction.

## Description

### Technical field

The present invention generally relates to the field of pattern generation using laser lithography. In particular, it pertains to the determination of dosage of laser sweeps in multi-beam laser lithography.

### Background

Existing pattern generation methods for mask writing systems generate patterns by exposing a photo sensitive mask using one or more laser beams.

Critical dimension (CD) is a critical parameter of the mask writing systems. The critical dimension linearity (CD Linearity) could be defined as an error in width of a pattern being printed. When printing patterns the error in width of a line of a particular width will typically be larger for thinner lines.

Existing methods for compensation are fairly effective down to a certain width of approximately 4 pixels where the error becomes non-satisfactory such that the width of the printed line deviates much from the target width also with compensation. Therefore, there exist a need of a method which is effective for laser beams having pixel width less than 4 pixels.

### Summary

Thus, it would be advantageous to achieve a method that overcomes, or at least alleviates, the above-mentioned drawback. In particular, it would be desirable to improve the printing of patterns having width less than 4 pixels by determining the dosage of laser sweeps to obtain the required target width. This can be achieved by employing a method for determining dosage of laser sweeps in a Y direction for printing a line in the Y direction of a pattern. To better address one or more of these concerns, a method for determining dosage of laser sweeps, having the features defined in the independent claim is provided. Preferable embodiments are defined in the dependent claims.

According to a first aspect, a method for determining dosage of laser sweeps in a Y direction for printing a line in the Y direction of a pattern, is provided. The method comprises, receiving a target width in an X direction and a target position in the X direction of a line to be printed. The target width is equal to or larger than two pixels and less than or equal to three pixels. The X direction and the Y direction are perpendicular to each other. The method further comprises, determining, from empirical data, a respective dosage for each of a set of parallel laser sweeps to achieve the target width in the X direction and the target position in the X direction. The empirical data maps the target width in the X direction and the target position in the X direction to a required dosage for each laser sweep of the set of parallel laser sweeps for achieving the target width in the X direction and the target position in the X direction.

Several advantages are associated with the present invention. Firstly, determining the respective dosage for each of a set of parallel laser sweeps from the empirical data effectively reduces a deviation of the printed line width from the target width. Secondly, determining the respective dosage for each of a set of parallel laser sweeps from the empirical data effectively reduces deviation of the position of the printed line from the target position in the X direction.

Furthermore, the nonlinear relation between CD and dosage affects the deviation in the printed line width and position at small target widths (i.e., 2 to 3 pixels) and is practically challenging or sometimes impossible to adapt using analytic methods. The use of empirical data enables the adaption. Additionally, the analytic methods require significant computing power and is time consuming, and therefore cannot be performed in real time, e.g. when generating patterns.

For a linear speed of a laser sweep, the dosage may be set by setting the intensity of the laser over the sweep.

The intensity of a laser can be expressed in terms of relative intensity or nominal intensity. Relative laser intensity is a way of indicating a laser intensity in relation to pixels and may for example be defined by 100% relative laser intensity corresponding to a laser intensity selected to achieve a desired exposure over adjacent pixels for which 100% of the area of the pixel should be exposed according to the pattern. The percentage of the relative intensity is indicated in relation to nominal intensity. As nominal intensity an isofocal intensity may be used.

The target width in the X direction is the width in X-direction of a line in the pattern as printed along the Y direction.

The target position in the X direction may be defined as the position of a line in the pattern along the X direction. The target position in the X direction may alternatively be defined as the required position of centre of the line in the pattern along the X direction.

The pixel may for example be the smallest unit used in modulation in relation to a pattern to be printed and is generally related to the width of one laser sweep.

The empirical data may comprise a plurality of subsets. Each subset of the plurality of subsets may correspond to a respective deviation from two pixels width in the X direction. Each subset of the plurality of subsets may comprise plurality of sub-subsets. Each sub-subset of each subset may comprise data representing the respective dosage for each laser sweep of the set of parallel laser sweeps to achieve the corresponding target position in the X direction.

In other words, the empirical data may be defined as a data set that comprises the plurality of subsets.

Exemplary, the empirical data may comprise plurality of tables, analogous to the plurality of subsets. Each table of the plurality of tables, may correspond to the respective deviation from two pixels width in the X direction. Each table of the plurality of tables may comprise a plurality of rows analogous to the plurality of sub-subsets. Each table of the plurality of tables may comprise a plurality of rows representing the respective dosage for each laser sweep of the set of parallel laser sweeps to achieve the corresponding target position in the X direction.

The target width may be provided as a deviation from two pixels width. The respective dosage for each of a set of parallel laser sweeps to achieve the target width in the X direction and the target position in the X direction may be provided in the subset corresponding to the determined deviation of the target width and the sub-subset of that subset corresponding to the target position in the X direction.

A total number of subsets of the plurality of subsets may be set to achieve a desired granularity of the target width in the X direction.

If the total number of subsets is increased, the granularity of the target width in the X direction becomes finer, thereby improving precision. Conversely, if the total number of subsets is decreased, the granularity of the target width in the X is reduced, resulting in lower precision.

A total number of sub-subsets of the plurality of sub-subsets may be set to achieve a desired granularity of the target position in the X direction.

The deviation in the target width may range from zero to a width of one pixel.

The dosage of one or more laser sweeps of the set of parallel laser sweeps may be achieved by means of multiple passes.

The multiple passes of at least one of the one or more laser sweeps may have different dosages.

The dosage of a laser sweep may be achieved by setting an intensity of a laser in the laser sweep.

The term pixel may also be defined as a unit that can be printed using a single laser sweep.

The number of laser sweeps of the set of parallel laser sweeps may be two or three.

The set of parallel laser sweeps may be defined as non-zero sweeps in the target width.

According to a second aspect, a computer readable storage medium comprising computer readable instructions is provided. The computer readable instructions which, when executed by a device having processing capability, causes the device to carry out the method of any of the first aspect.

According to a third aspect, a computer program comprising computer readable instructions is provided. The computer readable instructions which, when executed by a device having processing capability, causes the device to carry out the method of any of the first aspect.

According to a fourth aspect, a system for printing a pattern is provided. The system comprises a processor, a mask printing device, and a computer readable storage medium comprising computer readable instructions which, when executed by the processor, causes the processor to carry out the method of any of the first aspect.

### Brief description of the drawings

These and other aspects will now be described in more detail with reference to the appended drawings showing embodiments.
Figure 1a schematically illustrates a printing device;
Figure 1b shows a method for determining dosage of laser sweeps in a Y direction for printing a line in the Y direction of a pattern;
Figure 2 schematically illustrates a system for printing a pattern;
Figure 3a schematically illustrates a line to be printed in the Y direction;
Figure 3b further illustrates gaussian curves representing respective dosage for each of a set of parallel laser sweeps to achieve the target width and the target position in the X direction;
Figure 4a schematically illustrates an exemplary embodiment of the empirical data;
Figure 4b illustrates percentage dose chart corresponding to one of the table of the plurality of tables in figure 4a.

All the figures are schematic, not necessarily to scale, and generally only show parts which are necessary in order to elucidate the embodiments, wherein other parts may be omitted or merely suggested. Like reference numerals refer to like elements throughout the description.

### Detailed description

The present aspects will now be described more fully hereinafter with reference to the accompanying drawings, in which currently preferred embodiments are shown. This invention may, however, be embodied in many different forms and should not be construed as limited to the embodiments set forth herein; rather, these embodiments are provided for thoroughness and completeness, and fully convey the scope of the present aspects to those skilled in art.

The invention may be applied, for example, to multi-beam laser lithography. Additionally, the invention may be applied for printing lines in Y direction that is less than 4 pixels wide. Additionally, the invention may also be applicable to printing lines in X direction that is less than 4 pixels wide. In the present type of mask printing device, micro sweeping of the exposure beam is utilized. By allowing the beams to be swept a small distance in a direction perpendicular to the main motion direction of the printing head, the width of the printed strip is increased, which also increases the overall throughput. It will be understood that the actual degree of exposure also depends on the intensity of the exposure beam at each position.

From this, it is understood that the precision properties of the pattern in the X and Y directions, respectively, are partly governed by different apparatus properties. The precision in Y direction is highly dependent on e.g. the accuracy of the intensity variation control during a micro sweep, or the uniformity of the micro sweep speed. The precision in X direction is instead dependent on the accuracy of the printing head motion and the repeatability of the micro sweep conditions.

One of the most important features of a pattern printing system is CD Linearity in X and Y. CD linearity is defined as measured linewidth deviation (pattern width deviation) as a function of pattern linewidth (pattern width). The characteristics of a typical mask printer or direct printer system of today is that X linearity drops before Y linearity. This sets the practical useful resolution of the writer system for production.

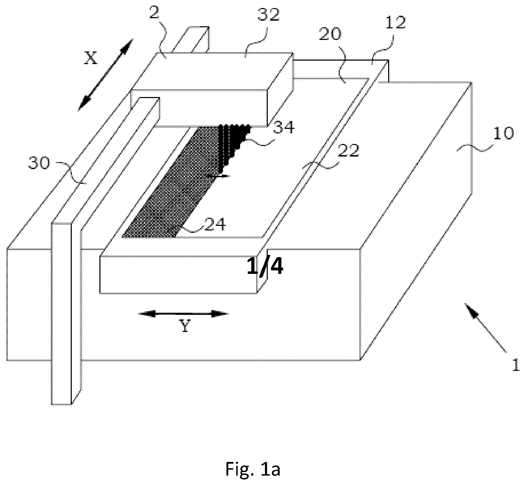

Figure 1a illustrates schematically a printing device 1 comprising a table 10, on which a workpiece support 12 is arranged. The workpiece support 12 is movable in a direction Y relative the table 10. On the workpiece support 12, a workpiece 20 is firmly attached. The surface of the workpiece 20 is provided with a layer sensitive to electromagnetic or particle radiation.

The printing device 1 further comprises a workpiece patterning device 2. The workpiece patterning device 2 comprises a stand 30 supporting a printing head 32. The printing head 32 is movable along the stand 30 in a direction X. The printing head 32 is arranged for providing an exposure beam 34 for exposure with electromagnetic or particle radiation, which exposure beam 34 is directed towards the workpiece 20. The exposure beams 34 are typically micro swept, as illustrated by the double arrow, synchronously with each other.

The combined motion of the workpiece support 12 and the motion of the printing head 32 and, by a micro sweeping of the exposure beam 34, makes it possible to reach all areas on the workpiece 20 that are supposed to be exposed for radiation. In the figure, an exposed area 24 and an unexposed area 22 are illustrated.

As anyone skilled in the art realizes, the relative mechanical motions can in other embodiment also be achieved in other ways, e.g. that the printing head 32 is movable in two dimensions and/or that the workpiece support 12 is movable in two dimensions.

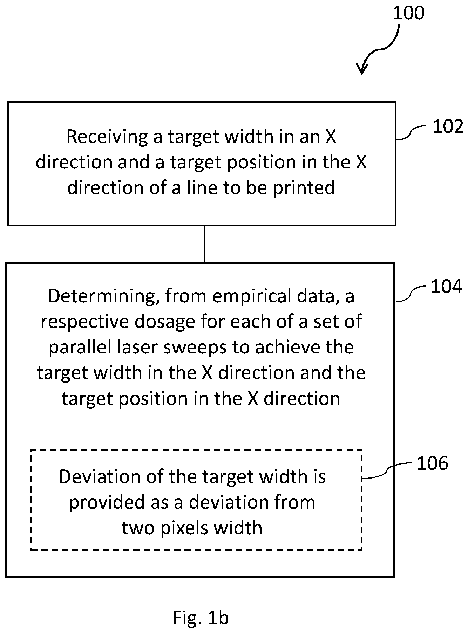

Figure 1b schematically illustrates an embodiment of a method 100 for determining dosage of laser sweeps in a Y direction for printing a line in the Y direction of a pattern. The method 100 comprises, receiving 102 a target width in an X direction and a target position in the X direction of a line to be printed. The target width is equal to or larger than two pixels and less than or equal to three pixels. The X direction and the Y direction are perpendicular to each other. The method 100 further comprises, determining 104, from empirical data, a respective dosage for each of a set of parallel laser sweeps to achieve the target width in the X direction and the target position in the X direction. The empirical data maps the target width in the X direction and the target position in the X direction to a required dosage for each laser sweep of the set of parallel laser sweeps for achieving the target width in the X direction and the target position in the X direction.

In the method 100, the target width may be provided 106 as a deviation from two pixels width. The respective dosage for each of a set of parallel laser sweeps to achieve the target width in the X direction and the target position in the X direction may be provided in the subset corresponding to the determined deviation of the target width and the sub-subset of that subset corresponding to the target position in the X direction.

The deviation in the target width may range from zero to a width of one pixel. The pixel may be defined as a unit that can be printed using a single laser sweep. In other words, the pixel may be a square area unit, that is exposed by one sweep at a time.

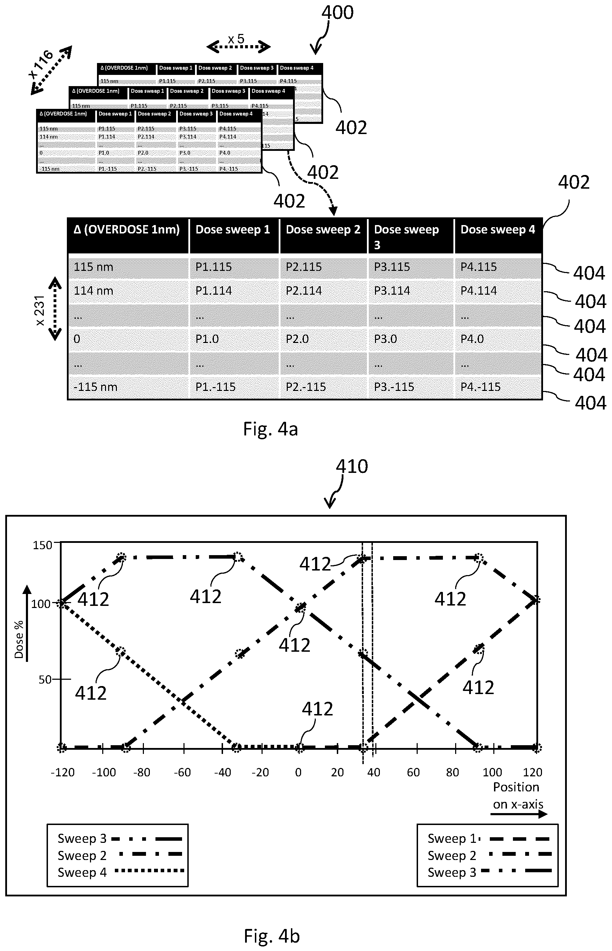

The empirical data may comprise a plurality of subsets. Each subset of the plurality of subsets may correspond to a respective deviation from two pixels width in the X direction. Each subset of the plurality of subsets may comprise plurality of sub-subsets. Each sub-subset of each subset may comprise data representing the respective dosage for each laser sweep of the set of parallel laser sweeps to achieve the corresponding target position in the X direction. The empirical data is described further with the help of an exemplary embodiment illustrated using Figure 4.

A total number of subsets of the plurality of subsets may be set to achieve a desired granularity of the target width in the X direction. While, a total number of sub-subsets of the plurality of sub-subsets may be set to achieve a desired granularity of the target position in the X direction.

The dosage of one or more laser sweeps of the set of parallel laser sweeps may be achieved by means of multiple passes or by means of a single pass. The multiple passes of at least one of the one or more laser sweeps may have different dosages. The dosage of a laser sweep may be achieved by setting an intensity of a laser in the laser sweep. The number of laser sweeps of the of the set of parallel laser sweeps may be two or three. The set of parallel laser sweeps may be defined as non-zero sweeps in the target width.

The dosage of a laser sweep depends on the intensity of the laser and the speed of the laser sweep. For a linear speed of the laser sweep, the dosage is set by setting the intensity of the laser over the sweep.

The intensity of a laser can be expressed in terms of relative intensity. Relative laser intensity is a way of indicating a laser intensity in relation to pixels and may for example be defined by 100% relative laser intensity corresponding to a laser intensity selected to achieve a desired exposure over pixels for which 100% of the area of the pixel should be exposed according to the pattern. With relative laser intensity of 100% the dosage will also be 100%.

By multiple passes is meant that a laser sweep passes the same pixels multiple times. By allowing multiple passes a certain dosage can be achieved by either one sweep or multiple sweep. For example, 100% dosage may be achieved by one sweep using 100% laser intensity, by two passes using 50% laser intensity each etc. Furthermore, the laser intensity of the laser in different passes does not need to be the same.

While in some embodiments, to achieve the required target width it may be possible that using only a single pass for one or more (or even all) of the set of parallel laser sweeps.

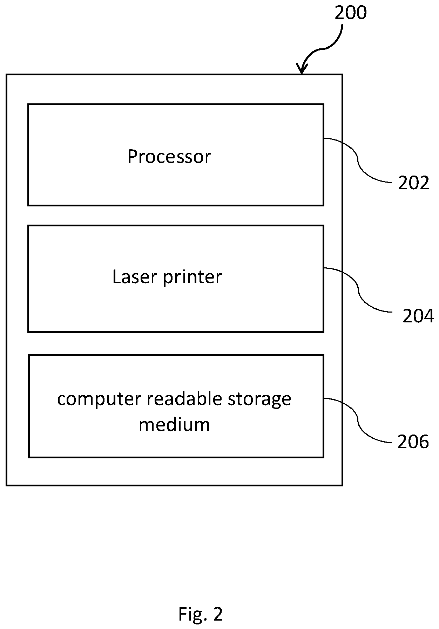

Figure 2 schematically illustrates a system 200 for printing a pattern. The system 200 comprises a processor 202, a mask printing device 204, and a computer readable storage medium 206. The computer readable storage medium 206 comprises computer readable instructions which, when executed by the processor, causes the processor to carry out the method 100 illustrated using Figure 1.

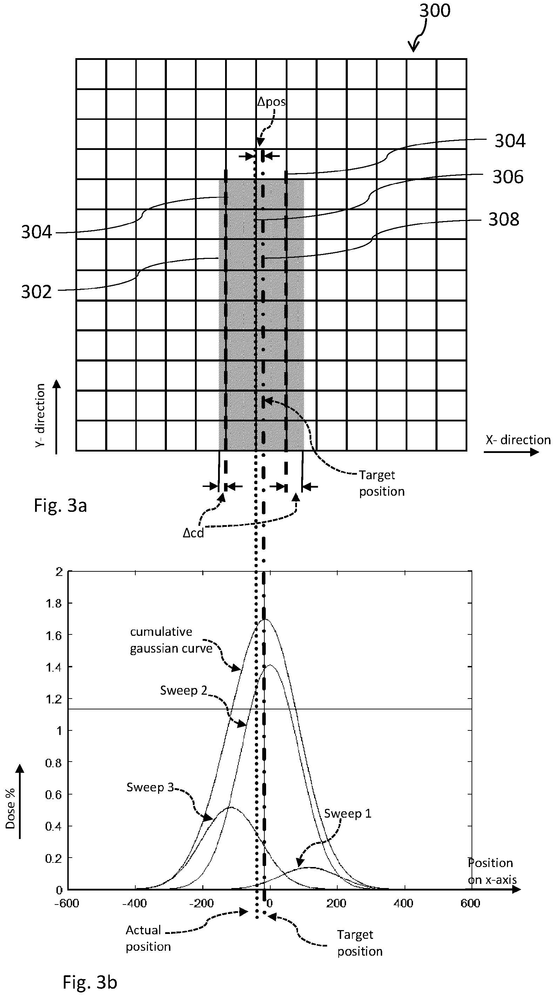

Figure 3a schematically illustrates in grey a line 302 to be printed in the Y direction of a pattern. Figure 3a further illustrates a deviation in the target width, Δcd, in an X direction and a deviation in the target position, Δpos, in the X direction of the line to be printed. The deviation in the target width, Δcd, in an X direction may also be referred to as critical dimension. The target width of the line 302 to be printed in an X direction is provided as a deviation from two pixels width. The two pixels width is illustrated by the two dashed lines 304 and the deviation is illustrated by Δcd in Figure 3a. Additionally, the target position of the line 302 to be printed is shifted by a value of Δpos in the X direction. In Figure 3a the shift is illustrated from the centre of the two pixels between the two dashed lines 304 which centre is illustrated by the dotted line 306 and the centre of the line 302 to be printed which centre is illustrated by the dash-dotted line 308 at the target position. In other words, the line 302 is an extension by Δcd in the X direction in relation to two pixels width illustrated by the two dashed lines 304 and a shift in the X direction by a value of Δpos in relation to the two pixels width illustrated as the two dashed lines 304.

Figure 3b further illustrates gaussian curves representing respective dosage for each of a set of parallel laser sweeps, sweep 1, sweep 2, sweep 3, to achieve the target width in the X direction and the target position in the X direction. The target position of the line 302 to be printed is achieved by shifting the line 302 in the X direction to the target position by shifting the line 302 to the right by a value of Δpos. In order to achieve the target width and the target position, each of the parallel laser sweeps, sweep 1, sweep 2, sweep 3 of the set of parallel laser sweeps is provided with a respective determined dosage from the empirical data. Sweep 2 as shown in the figure has a dosage of approximately 40% of a nominal dosage. The nominal dosage for example here is 100%. Similarly, Sweep 3 has approximately 50% of the nominal dosage, while sweep 1 has approximately 20% of the nominal dosage. The final gaussian effect of the three sweeps, i.e., sweep 1, sweep 2 and sweep 3, is shown by the cumulative gaussian curve having the desired target position and target width.

Figure 4a schematically illustrates an exemplary embodiment of the empirical data 400. The empirical data 400 is illustrated to comprise a plurality of tables 402 analogous to the plurality of subsets. A total number of the plurality of tables 402 shown here are for example one hundred and sixteen. Each table of the plurality of tables 402, corresponds to the respective deviation from two pixels width in the X direction. For instance, first table of the plurality of tables 402, corresponds to a deviation of 1 nm from two pixels width in the X direction. Second table of the plurality of tables 402, corresponds to a deviation of 2 nm from two pixels width in the X direction. Similarly, this applies to third, fourth, and subsequent tables of the plurality of tables 402. Table one hundred and sixteen of the plurality of tables 402, corresponds to a maximum deviation of 116 nm from two pixels width in the X direction. Each table of the plurality of tables 402 may comprise a plurality of rows 404 analogous to the plurality of sub-subsets. Each table of the plurality of tables 402 comprising a plurality of rows 404 representing the respective dosage for each laser sweep of the set of parallel laser sweeps to achieve the corresponding target position in the X direction. Therefore, once a table is selected from the plurality of tables 402, corresponding to the respective deviation from two pixels, the next step of the method 100 may comprise determining a row from the plurality of rows 404 in the selected table of the plurality of tables 402 that corresponds to the target position Δpos in the X direction of the line to be printed.

The total number of the plurality of tables 402 may be set to achieve a desired granularity of the target width in the X direction. The total number of the plurality of tables 402 shown here are for example one hundred and sixteen. If the total number of the plurality of tables 402 are increased, then the granularity of the target width in the X direction may improve, and vice versa. Similarly, a total number of the plurality of rows 404 may be set to achieve a desired granularity of the target position in the X direction. For instance, as shown in the table, the number of rows is two hundred and thirty one, allowing the target position in the X direction to be adjusted both to the left and right from an on grid position, ranging from -115 nm to 115 nm.

The percentage dose chart 410 illustrated using Figure 4b, corresponds to one of the table of the plurality of tables 402. The percentage dose chart 410 illustrates, on one of the co-ordinate axis, position of the line on x-axis, and on the other co-ordinate axis, percentage dose with respect to 100% dose. Additionally, the percentage dose chart 410 further represents sweep 1, sweep 2, sweep 3, and sweep 4, each with corresponding dose percentage, dose percentage, at different positions on the x-axis. The percentage dose chart 410 also indicates specific positions on x-axis where the corresponding dose percentage 412 could be identified, while the dose percentage at other positions on the x-axis can be interpolated. This is an example of how to create a table using measurements at the specific positions that could be identified and other positions where it can be interpolated. Hence, the dosages for the different sweeps are determined empirically for a set of positions on the x-axis, e.g. -120, -100, ... , -20, 0, 20, ..., 100, 120 as in chart 410. Dosage for the different sweeps in points in between are interpolated. This reduces the number of times printing and measurement needs to be done in order to determine suitable dosage for the different sweeps at the different positions along the x-axis.

Additionally or alternatively, the interpolation may be used between tables 402. Hence, not all tables need to be created by printing and measuring for a number of location along the x-axis as described above. It may be sufficient to do this for a subset of the plurality of tables 402, then create the other tables based on interpolation according to the method described above by interpolation between tables. While the present disclosure has been illustrated and described in detail in the drawings and foregoing description, such illustration and description are to be considered illustrative or exemplary and not restrictive.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain features are recited in mutually different dependent claims does not indicate that a combination of these features cannot be used to advantage. Any reference signs in the claims should not be construed as limiting the scope.

## Claims

1. A method (100) for determining dosage of laser sweeps in a Y direction for printing a line in the Y direction of a pattern, the method comprising:
receiving (102) a target width in an X direction and a target position in the X direction of a line to be printed, wherein the target width is equal to or larger than two pixels and less than or equal to three pixels, wherein the X direction and the Y direction are perpendicular;
determining (104), from empirical data, a respective dosage for each of a set of parallel laser sweeps to achieve the target width in the X direction and the target position in the X direction, wherein the empirical data maps the target width in the X direction and the target position in the X direction to a required dosage for each laser sweep of the set of parallel laser sweeps for achieving the target width in the X direction and target position in the X direction.

2. The method of claim 1, wherein the empirical data comprises a plurality of subsets, wherein each subset of the plurality of subsets corresponds to a respective deviation from two pixels width in the X direction, and each subset of the plurality of subsets comprises plurality of sub-subsets, wherein each sub-subset of each subset comprises data representing the respective dosage for each laser sweep of the set of parallel laser sweeps to achieve the corresponding target position in the X direction.

3. The method of claim 2, wherein the target width is provided as a deviation from two pixels width, and wherein the respective dosage for each of the set of parallel laser sweeps to achieve the target width in the X direction and the target position in the X direction is provided in the subset corresponding to the determined deviation of the target width and the sub-subset of that subset corresponding to the target position in the X direction.

4. The method of any one of claims 2 and 3, wherein a total number of subsets of the plurality of subsets is set to achieve a desired granularity of the target width in the X direction.

5. The method of any one of claims 2 and 4, wherein a total number of sub-subsets of the plurality of sub-subsets is set to achieve a desired granularity of the target position in the X direction.

6. The method of any of the claims 2 to 5, wherein the deviation in the target width ranges from zero to a width of one pixel.

7. The method of any one of claims 1 to 6, wherein the dosage of one or more laser sweeps of the set of parallel laser sweeps is achieved by means of multiple passes.

8. The method of claim 7, wherein the multiple passes of at least one of the one or more laser sweeps have different dosages.

9. The method of any one of claims 1 to 8, wherein the dosage of a laser sweep is achieved by setting an intensity of a laser in the laser sweep.

10. The method of any of the claims 1 and 9, wherein the pixel is a unit that is printed using a single laser sweep.

11. The method of any of the claims 1 and 10, wherein the number of laser sweeps of the of the set of parallel laser sweeps is two or three.

12. The method of any one of claims 1 and 11, wherein the set of parallel laser sweeps are non-zero sweeps in the target width.

13. A computer readable storage medium comprising computer readable instructions which, when executed by a device having processing capability, causes the device to carry out the method of any of claims 1-12.

14. A computer program comprising computer readable instructions which, when executed by a device having processing capability, causes the device to carry out the method of any of claims 1-12.

15. A system (200) for printing a pattern, the system comprising:
a processor (202),
a mask printing device (204), and
a computer readable storage medium (206) comprising computer readable instructions which, when executed by the processor, causes the processor to carry out the method (100) of any of the claims 1-12.
